(19) **Europäisches Patentamt**

**European Patent Office**

**Office européen des brevets**

(11) Publication number : **0 599 609 A1**

(12) **EUROPEAN PATENT APPLICATION**

(21) Application number : **93309345.2**

(22) Date of filing : **24.11.93**

(51) Int. Cl.⁵ : **H03L 7/16**

(30) Priority : **25.11.92 JP 315008/92**

(43) Date of publication of application :
**01.06.94 Bulletin 94/22**

(84) Designated Contracting States :
**DE FR GB**

(71) Applicant : **NEC CORPORATION**
**7-1, Shiba 5-chome**
**Minato-ku**
**Tokyo 108-01 (JP)**

(72) Inventor : **Ooga, Toshiyuki, c/o NEC**
**Corporation**
**7-1 Shiba 5-chome**
**Minato-ku, Tokyo 108-01 (JP)**

(74) Representative : **Abnett, Richard Charles et al**
**REDDIE & GROSE**
**16 Theobalds Road**
**London WC1X 8PL (GB)**

(54) **Frequency synthesizing apparatus for a communication system.**

(57) A phase-locked loop frequency synthesizing apparatus has a voltage controlled oscillator (4) which is supplied with a control voltage derived from the output of a phase comparator (2) one input of which receives a reference frequency. A direct digital synthesizer (5) frequency-divides the output frequency signal with a non-integral decimal dividing function to produce a phase-comparative frequency signal for application to the other input of the phase comparator. The apparatus can be used in microwave, mobile or similar communications apparatus.

FIG. 2

BACKGROUND OF THE INVENTION

The present invention relates to a frequency synthesizing apparatus for use in a microwave, mobile or similar communication system.

In a microwave or mobile communication system, for example, a number of carriers are often arranged at relatively narrow frequency intervals to provide large capacity communication system. In this case, receivers and repeaters included in the system should have function to perform frequency acquisition surely and rapidly. It has been customary to provide receivers and repeaters equipped with a frequency synthesizing apparatus using a phase-locked loop (PLL) circuit.

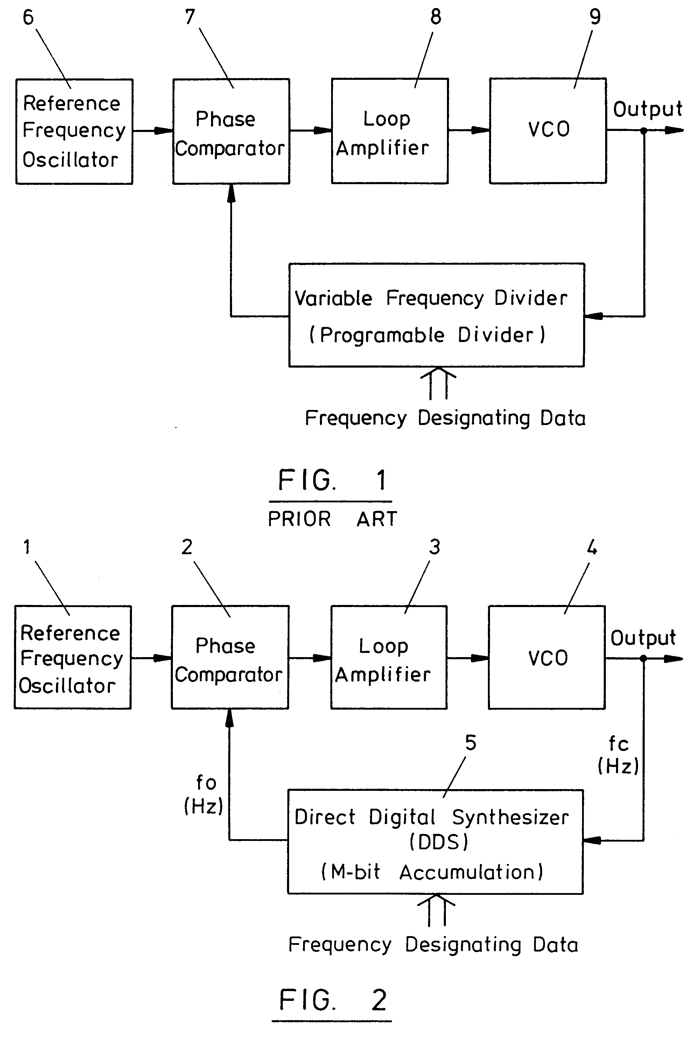

Fig. 1 shows a conventional frequency synthesizing apparatus using a PLL circuit as mentioned above. As shown, the apparatus includes a voltage controlled oscillator (VCO) 9, a variable (programable) frequency divider 10 for dividing the output frequency of the VCO 9 to produce a phase-comparative frequency signal, a reference frequency oscillator 6 for generating a reference frequency signal, a phase comparator 7 for comparing the phase of the reference frequency signal and the phase of the phase-comparative frequency signal from the frequency divider 10 and a loop amplifier 8 having a desired loop filtering characteristic. Conventionally, the variable frequency divider 10 is composed of an integral frequency divider. The problem with the synthesizing apparatus using the integral frequency divider is that when the output frequency signal is to be changed, a step frequency should not be lower than the comparative frequency in the phase comparator 7. Conversely, if a PLL having a low step frequency is designed, the comparative frequency in the phase comparator 7 is lowered, resulting in the following problems:

(1) A broad loop band is not available;
(2) The limited loop band due to above increases the frequency acquisition time; and
(3) Phase noise, particularly generated in the phase comparator 7 is multiplied in accordance with the divisor of the frequency divider.

Therefore, a high speed and large capacity communication system, which solves the above problems, has not been realized yet.

The invention is defined in claim 1 below to which reference should now be made. Advantageous features of the invention are set forth in the sub-claims.

A preferred frequency synthesizing apparatus embodying the present invention, described in more detail below, comprises a voltage controlled oscillator (VCO), a direct digital synthesizer for receiving an output of the VCO as an input clock frequency and for dividing the frequency of the input clock frequency to thereby generate a phase-comparative frequency signal, a reference frequency oscillator for generating the reference frequency signal, a phase comparator for comparing the phase of the phase-comparative frequency signal and the phase of the reference frequency signal to thereby produce a phase error signal, and a loop amplifier receiving the phase error signal for filtering it with a desired response characteristic of a loop to generate a control signal. The direct digital synthesizer can divide the input clock frequency by a decimal or non-integral value.

The preferred frequency synthesizing apparatus is capable of reducing the step of the output frequency without lowering the reference frequency and the comparative frequency. It allows the phase-comparative frequency of the PLL to be selected freely without the restriction that it is below the step frequency. It also permits the broad loop band for the PLL and thereby rapid frequency acquisition.

The above and other objects, features and advantages of the present invention will become more apparent from the following detailed description taken with the accompanying drawings in which:

Fig. 1 is a block diagram schematically showing a conventional frequency synthesizing apparatus,

Fig. 2 is a schematic block diagram showing a frequency synthesizing apparatus embodying the present invention;

Fig. 3 is a block diagram schematically showing a direct digital synthesizer included in the embodiment; and

Figs. 4 and 5 are graphs representative of the operation of the direct digital synthesizer.

DESCRIPTION OF THE PREFERRED EMBODIMENT

Referring to Fig. 2 of the drawings, a frequency synthesizing apparatus embodying the present invention includes a VCO 4. A direct digital synthesizer 5 receives the output $f_c$ (Hz) of the VCO 4 at the clock input terminal thereof and converts it to phase-comparative reference frequency $f_o$ (Hz). Assume that the direct digital synthesizer 5 has an operational accumulator having m bits, and that frequency designating data applied to the synthesizer 5 is n (integer). Then, the synthesizer 5 converts the input clock frequency $f_c$ to the output phase-comparative frequency $f_o$ expressed as:

$$f_o = \frac{n}{2^m} f_c \qquad \text{Eq. (1)}$$

where $2f_o$ is smaller than $f_c$. This means that the synthesizer 5 is capable of dividing the input by a decimal i.e. a non-integer value. If the Eq. (1) and a sampling theorem is satisfied, the clock frequency can be converted to any desired phase-comparative frequency.

A phase comparator 2 compares the output of the direct digital synthesizer 5 with a reference frequency signal generated by a reference frequency oscillator 1, thereby producing a phase error signal. The phase error signal is fed back to the VCO as its control signal 4 via a loop amplifier 3 which sets a desired loop filtering characteristic.

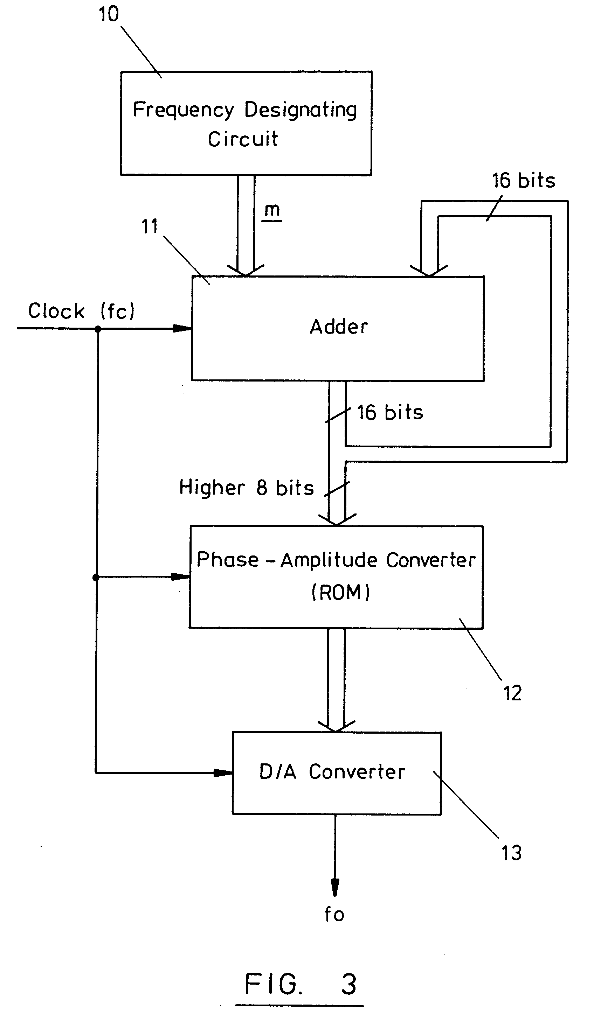

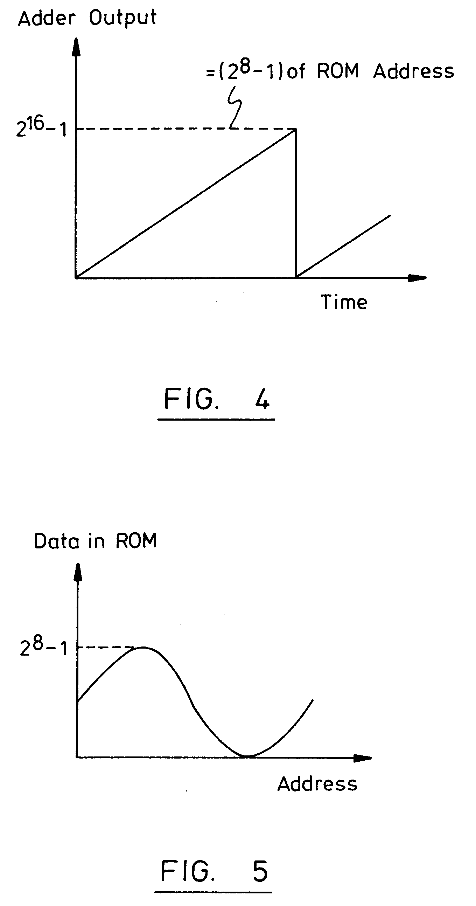

The direct digital synthesizer 5 will be described specifically with reference to Fig. 3. As shown, the synthesizer 5 has a frequency data setting circuit 10 for designating data indicative of the above-mentioned number n (binary). The number n is fed to an adder 11 having a predetermined number of bits (sixteen bits in the embodiment) which predetermined number corresponds to the accumulating bit number $\underline{m}$. The adder 11 adds the data of the number $\underline{n}$ to the output thereof in synchronism with the clock CK of the frequency $f_c$. Namely, the adder 11 has a function of integrating, i.e., accumulating the constant $\underline{n}$ with respect to time. In this case, since the number of bits of the adder 11 is limited and overflow occurs, the value of the output of the adder 11 changes in a saw-tooth configuration as shown in Fig. 4. When the clock frequency is constant, the gradient of ramps of the saw-tooth waveform is determined by the number $\underline{n}$. Therefore, the frequency $f_o$ of the saw-tooth waveform is determined by the number $\underline{n}$, giving the above Eq. (1)

The data of the saw-tooth waveform change are fed from the adder 11 to a phase-to-amplitude converter 12. It is noted that, in this embodiment, only several higher bits, eight bits in the embodiment, of the adder 11 are applied to the phase-to-amplitude converter 12. The phase-to-amplitude converter 12 is implemented by a ROM (Read Only Memory); Fig. 5 indicates a relation between the addresses of the ROM and the data stored therein. One period of the sinusoidal waveform shown in Fig. 5 corresponds to one period of the saw-tooth waveform shown in Fig. 4. Therefore, the frequency of the sinusoidal waveform is controlled by the above-mentioned constant $\underline{n}$ and given by the Eq. (1). It is noted here that the ratio between $f_o$ and $f_c$ is not always an integer, i.e., the direct digital synthesizer 5 has a decimal dividing function.

A digital-to-analog converter (DAC) 13 converts the output of the phase-to-amplitude converter (ROM) 12, i.e., the sinusoidal wave amplitude data, to an analog sinusoidal waveform in synchronism with the clock CK. Equivalently, therefore, the DAC 13 reproduces the sinusoidal waveform sampled at the frequency $f_c$. It follows that a condition $2f_o < f_c$ is derived from the sampling theorem.

It will be seen from the above that the direct digital synthesizer 5 performs the frequency conversion as represented by the Eq. (1). According to the present invention, the direct digital synthesizer 5 is introduced in the PLL to constitute a frequency synthesizing apparatus. Hence, the decimal dividing function of the direct digital synthesizer 5 enables the frequency synthesizing apparatus to have a narrow step frequency, while maintaining the phase-comparative frequency high. This is successful in eliminating the prior art problems discussed previously.

Specifically, assume that the phase-comparative frequency $f_o$ is 1 MHz, and that the accumulator width $\underline{m}$ is sixteen. Then, the output frequency $f_c$ of the VCO is 4 MHz when $\underline{n}$ is 16,384, and 4.00024415 ... MHz when $\underline{n}$ is 16,383, as determined by the Eq. (1). As a result, a frequency synthesizing apparatus whose step frequency is as low as 244.15 Hz is achieved. Furthermore, when the direct digital synthesizer 5 is provided with a 32-bit accumulator and the output of the VCO 4 is 6 GHz, even a frequency synthesizing apparatus variable on a 1.4 Hz step basis can be implemented.

In summary, it will be seen that the present system provides a frequency synthesizing apparatus having a direct digital synthesizer in a PLL thereof and, therefore, achieves various unprecedented advantages, as enumerated below.

(1) A PLL frequency synthesizing apparatus having a low step frequency can be realized without lowering the phase-comparative reference frequency.

(2) By selecting a high phase-comparative reference frequency, it is possible to broaden the loop band and, therefore, to compress a phase noise generated in a loop.

(3) The broad loop band promotes rapid frequency-lock acquisition when a frequency is changed.

(4) The frequency synthesizing apparatus of the present invention is resistive to microphonism.

## Claims

1. A frequency synthesizing apparatus comprising:

a voltage controlled oscillator (VCO) (4) for generating an output frequency signal ($f_c$);

a direct digital synthesizer (5) for receiving said output frequency signal from said VCO as an input clock frequency, and dividing a frequency of said output frequency signal to thereby generate a phase-comparative frequency signal ($f_o$);

a reference frequency oscillator (1) for generating a reference frequency signal;

a phase comparator (2) for phase-comparing said phase-comparative frequency signal and said reference frequency signal to thereby produce a phase error signal; and

a loop means (3) receiving said phase error signal for generating a control signal for said VCO.

2. A frequency synthesizing apparatus as claimed in claim 1, wherein said direct digital synthesizer (5) divides said input clock frequency by a decimal.

3. A frequency synthesizing apparatus as claimed in claim 1 or 2, wherein said direct digital synthesizer (5) includes:

       frequency designating means (10) for delivering frequency designating data;

       an adder (11) for adding said frequency designating data in response to said output frequency signal to produce phase data;

       a phase-amplitude converter (12) for converting said phase data delivered from said adder into sinusoidal wave amplitude data; and

       a digital-to-analog converter (13) for converting said sinusoidal wave amplitude data into an analog signal, said analog signal corresponding to said phase-comparative frequency signal.

4. A frequency synthesizing apparatus as claimed in claim 3, wherein a frequency $f_c$ of said output frequency signal and a frequency $f_o$ of said phase-comparative frequency signal are expressed as $f_o + (n/2^m)f_c$ when said frequency designating data represents number $\underline{n}$ (integer) and said adder has an accumulating bits of $\underline{m}$ (integer).

5. A frequency synthesizing apparatus as claimed in any preceding claim, wherein said loop means comprises a loop filter means (3).

FIG. 1

PRIOR ART

FIG. 2

10

Frequency Designating
Circuit

11

Clock (fc)

$\underline{m}$

16 bits

Adder

16 bits

Higher 8 bits

Phase – Amplitude Converter
(ROM)

12

D/A Converter

13

fo

# FIG. 3

FIG. 4

FIG. 5

**European Patent Office**

## EUROPEAN SEARCH REPORT

Application Number

EP 93 30 9345

### DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| X | US-A-4 965 533 (GILMORE)<br>* column 2, line 31 - line 48 *<br>* column 8, line 55 - column 9, line 57; figure 3 *<br>* column 5, line 22 - line 35; figure 2 * | 1-5 | H03L7/16 |
| X | EP-A-0 454 917 (HEWLETT-PACKARD LIMITED)<br>* column 2, line 21 - column 5, line 12; figures 1,2 * | 1-5 | |
| X | EP-A-0 388 313 (JOHN FLUKE MFG. CO., INC.)<br>* page 4, line 35 - page 6, line 53; figures 2-4 * | 1-5 | |
| | | | TECHNICAL FIELDS SEARCHED (Int.Cl.5) |
| | | | H03L |

The present search report has been drawn up for all claims

| Place of search | Date of completion of the search | Examiner |
|---|---|---|
| THE HAGUE | 19 January 1994 | Balbinot, H |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)